# DEMANDE DE BREVET EUROPEEN

(11) **EP 3 697 188 A1**
(43) Date de publication de la demande: **19.08.2020**
(21) Numéro de dépôt: 20157060.3
(22) Date de dépôt: 13.02.2020
(51) Int. Cl.: H05K 13/04

(54) **PROCÉDÉ DE PRÉHENSION DE COMPOSANTS ÉLECTRONIQUES COMPORTANT DES BROCHES**

(30) Priorité: 14.02.2019 FR 1901490
(71) Demandeur: MGA Technologies, 69380 Civrieux d'Azergues (FR)
(72) Inventeur: de MALLIARD, Hervé, 69160 Tassin la Demi-Lune (FR)
(74) Mandataire: Chevalier, Renaud Philippe

(57) **Abrégé**

Procédé de préhension de composants électroniques (6) disposant de broches de contact électrique (16), ce procédé comportant successivement une étape de descente sensiblement verticale d'une tête de préhension (14) comprenant à sa base une forme de positionnement s'ajustant sur le corps du composant (6), et une pince à deux mors (20) équipée de deux becs inférieurs (22) venant de chaque côté d'une broche (16), une étape de fermeture des becs (22) sur cette broche (16), et enfin une étape de remontée et de déplacement de la tête de préhension (14).

## Description

La présente invention concerne un procédé de préhension de composants électroniques comportant des broches, ainsi qu'un système de préhension mettant en oeuvre un tel procédé.

Les composants électroniques comprenant un corps équipé de broches pour assurer les contacts électriques, sont de plus en plus utilisés. En particulier les véhicules automobiles comportent un nombre croissant de systèmes électroniques, notamment pour améliorer le contrôle de la combustion des moteurs thermiques ou pour commander des machines électriques de traction de véhicules hybrides ou électriques, tout ceci afin de réduire la consommation d'énergie et les émissions de gaz polluants, pour aider à la conduite, pour l'automatiser, ou pour de nombreuses autres fonctions afin d'améliorer le confort et la sécurité.

En particulier les capteurs à effet hall sont de plus en plus utilisés dans des systèmes mécatroniques, pour mesurer ou contrôler des déplacements ou des positions.

Les composants électroniques peuvent, lors de leur fabrication, être positionnés et placés avec un pas constant dans des alvéoles d'une bande support continue qui est enroulée sous forme de bobine. En variante les composants peuvent être fixés par les extrémités de leurs broches sur le côté d'une bande continue en carton formant des zigzags empilés dans une boite, disposés pour former des couches successives. Les machines utilisant ces composants déroulent la bobine, ou déplient le zigzag en coupant les extrémités des broches pour les détacher de la bande, en plaçant chaque composant les uns après les autres à un emplacement de préhension où il est pris pour être disposé à un poste de travail suivant.

Toutefois les dimensions des composants, ou leurs positionnements successifs sur la bande par rapport à la position théorique, peut être variable, avec des écarts de plusieurs dixièmes de millimètres d'un composant à l'autre, ce qui pose des difficultés de préhensions répétitives et fiables avec des cadences élevées, sans appliquer de contraintes mécaniques trop élevées sur ces composants. Des contraintes importantes peuvent entraîner des rebuts, détectés avant ou après le montage sur des ensembles, ce qui augmente les coûts.

Les procédés connus et les différents systèmes de préhension mettant en œuvre ces procédés, répondent mal à ces problèmes. La présente invention a notamment pour but d'éviter ces inconvénients de la technique antérieure.

Elle propose à cet effet un procédé de préhension de composants électroniques disposant de broches de contact électrique, remarquable en ce qu'il comporte successivement une étape de descente sensiblement verticale d'une tête de préhension comprenant à sa base une forme de positionnement s'ajustant sur le corps du composant, et une pince à deux mors équipée de deux becs inférieurs venant de chaque côté d'une broche, une étape de fermeture des becs sur cette broche, et enfin une étape de remontée et de déplacement de la tête de préhension.

Un avantage de ce procédé est que la forme de positionnement réalise un ajustement du corps du composant sur la tête de préhension, malgré des dispersions de positionnement de ce composant, ce qui permet aux mors de la pince de se positionner avec une bonne précision de chaque côté de la broche. La pince peut ensuite se fermer en assurant la prise de la broche, ce qui permet de déplacer et de mettre en référence mécanique le composant de manière fiable, efficace et rapide.

On obtient ainsi un procédé d'alimentation des postes de travail avec une cadence pouvant être élevée. De plus en adaptant la forme de positionnement et la position de la tête de préhension, on peut réaliser un système de préhension standard s'adaptant facilement à différents types de composants présentant des variétés de forme.

Le procédé de préhension selon l'invention, ainsi qu'un système de préhension mettant en œuvre ce procédé, peuvent comporter de plus une ou plusieurs des caractéristiques suivantes, qui peuvent être combinées entre elles.

Avantageusement, le procédé comporte une étape préliminaire de détection du composant à son emplacement de préhension avec une tête de lecture laser.

Avantageusement, le procédé comporte une étape finale de descente de la tête de préhension et de dépose du composant sur un posage horizontal.

Dans ce cas, avantageusement le procédé effectue la dépose du composant sur le posage avec un jeu latéral par rapport à un rebord de ce posage formant une mise en référence.

De plus, avantageusement après la dépose du composant sur le posage, le procédé applique un mouvement latéral de ce composant pour le mettre en contact avec le rebord de mise en référence.

De plus, après la mise en contact du composant avec le rebord de mise en référence, avantageusement le procédé commande le coulissement horizontal d'une lame souple liée au posage, venant en appui au-dessus du corps de ce composant.

Avantageusement, le procédé réalise l'étape de fermeture des becs sur la broche avec un effort maitrisé au moyen d'une élasticité disposée entre un actionneur et les becs.

Avantageusement, le procédé commande un moteur pas à pas formant l'actionneur de fermeture des becs.

L'invention a aussi pour objet un système de préhension de composants, remarquable en ce qu'il comporte une tête de préhension se déplaçant, mettant en œuvre un procédé de préhension comprenant l'une quelconque des caractéristiques précédentes.

En particulier, la tête de préhension peut se déplacer suivant un axe horizontal et un axe vertical.

En particulier, le système de préhension peut comporter un plateau tournant comprenant des posages répartis autour de ce plateau, recevant successivement les composants.

Selon un mode de réalisation, avantageusement la pince présentant un plan médian de symétrie, comporte une vis disposée dans ce plan, entraînant un coulissement d'une barre transversale portant de chaque côté un doigt engagé dans une lumière oblongue d'un des mors pour faire pivoter ce mors.

L'invention sera mieux comprise et d'autres caractéristiques et avantages apparaîtront plus clairement à la lecture de la description ci-après donnée à titre d'exemple, en référence aux dessins annexés dans lesquels :
[Fig. 1] présente un système de préhension d'une machine de coupe et cambrage des broches de composants disposés sur une bande, mettant en œuvre un procédé de préhension selon l'invention ;
[Fig. 2] est une vue en coupe suivant un plan de coupe vertical parallèle au plan de la pince, de la partie inférieure de la tête de préhension de ce système de préhension ;
[Fig. 3] présente la descente de la tête de préhension sur un composant à trois broches parallèles ;
[Fig. 4] est une vue de dessus de la pince venant autour de la broche centrale de ce composant ;
[Fig. 5] est une vue en coupe suivant un plan de coupe vertical parallèle au plan de la pince, présentant la pince venant autour de la broche centrale de ce composant ;
[Fig. 6] présente la fermeture de la pince ;
[Fig. 7] présente la montée de la tête de préhension emportant le composant ;
[Fig. 8] est une vue d'ensemble présentant l'arrivée du composant au-dessus d'un posage sur un plateau tournant ;
[Fig. 9] est une vue de détail présentant cette arrivée du composant au-dessus d'un posage sur un plateau tournant ;
[Fig. 10] est une vue en coupe suivant un plan vertical médian, présentant la descente de ce composant sur le posage ;
[Fig. 11] présente le déplacement latéral du composant pour un calage sur une référence ;
[Fig. 12] est une vue en perspective présentant le déplacement horizontal d'une fourchette de maintien du composant ;
[Fig. 13] est une vue en coupe suivant un plan vertical médian, présentant ce déplacement horizontal de cette fourchette de maintien du composant ; et
[Fig. 14] présente la remontée de la tête de préhension.

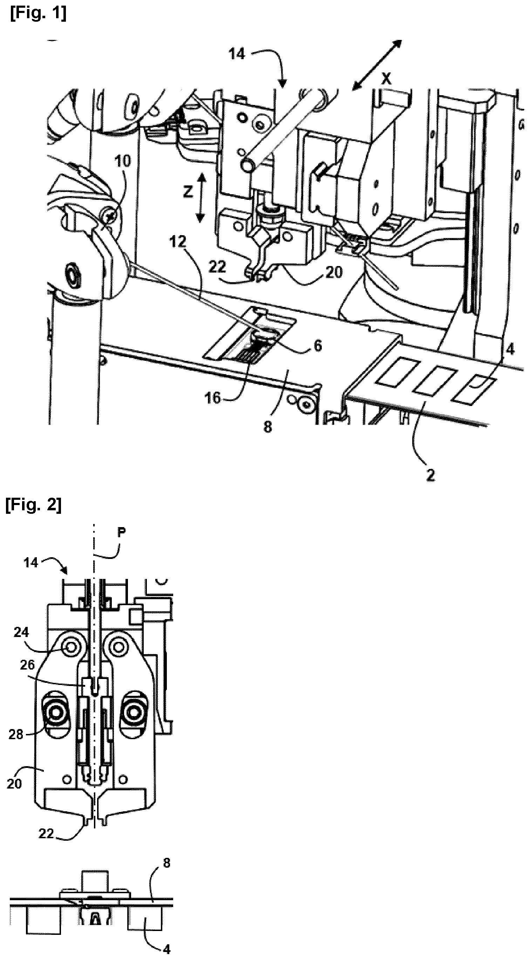

D'une manière générale le procédé de préhension selon l'invention peut s'appliquer à tous types de composants, comprenant un corps et au moins une broche, délivrés sur différents supports, en particulier sur une bande continue. La figure 1 présente une machine de coupe et cambrage de broches de composant, gérée entièrement par des commandes numériques programmées effectuant les différents contrôles des mouvements, qui s'adapte à différents types de composants comprenant des corps variés.

Une bande 2 assurant l'alimentation des composants électroniques 6, qui peuvent être amagnétiques, présente une succession d'alvéoles 4 disposées suivant un pas constant, formant des coques appelées blister en langue anglaise, contenant chacune un composant disposant de broches de liaison électrique 16. Dans cet exemple chaque composant 6 présente trois broches parallèles 16 disposées horizontalement, perpendiculairement à la direction de la bande 2.

La bande venant d'une bobine qui se déroule, coulisse dans un guidage comprenant une plaque supérieure 8 disposant d'une fenêtre, de manière à disposer successivement chaque composant devant cette fenêtre. Une tête de lecture laser 10 fixée sur un support, dirige un rayon laser 12 sur le composant 6 disposé dans la fenêtre, pour vérifier sa présence.

Une tête de préhension 14 de la machine, alignée verticalement au-dessus du composant 6 à saisir, comporte des guidages linéaires motorisés réalisant un mouvement vertical de la tête suivant l'axe Z, et un mouvement horizontal de cette tête suivant l'axe X.

La tête de préhension 14 comporte à sa base une forme de positionnement inférieur, comprenant une face inférieure plate entourée sur deux côtés de rebords. Après sa descente la face inférieure plate vient sur le corps du composant 6, les rebords encadrant les deux broches 16 des côtés ce qui positionne ce composant en le maintenant horizontalement.

La figure 2 présente la partie inférieure de la tête de préhension 14 comprenant deux mors 20 disposés symétriquement par rapport à un plan médian vertical P, comprenant chacun un bec inférieur 22, et en partie supérieure un pivot horizontal 24 disposé parallèlement au plan médian.

Une vis verticale 26 entraînée par un moteur électrique, disposée dans le plan médian P, est insérée dans un perçage fileté d'une barre transversale coulissant verticalement, comprenant de chaque côté un roulement 28 présentant un axe horizontal parallèle à ce plan médian. Chaque roulement 28 forme un doigt engagé dans une fenêtre oblongue de chaque mors 26, qui est légèrement inclinée par rapport à la verticale, ces fenêtres se rapprochant l'une de l'autre vers le bas.

De cette manière une rotation de la vis 26 entraînant la descente des roulements 28 engagés dans les fenêtres oblongues formant des profils de came, fait pivoter les deux mors 20 en rapprochant de manière progressive et précise les deux becs inférieurs 22 l'un de l'autre. La forte démultiplication entre la rotation de la vis 26 et les petits mouvements des becs 22 permet d'assurer une précision de ces mouvements.

On dispose de plus un ressort entre l'actionneur des becs 22 et ces becs, donnant une petite élasticité au niveau du serrage des mors qui limite les efforts de compression appliqués à la broche 16 utilisée pour déplacer le composant. On a ainsi moins de variation d'effort sur cette broche 16 venant des dispersions de sa largeur, ce qui garantit la préhension.

Avantageusement, on commande un moteur pas à pas formant l'actionneur de fermeture des becs 22, permettant de serrer la broche 16 sans excès, l'élasticité disposée entre l'actionneur et les becs permettant de prendre en compte les dispersions dimensionnelles de cette broche.

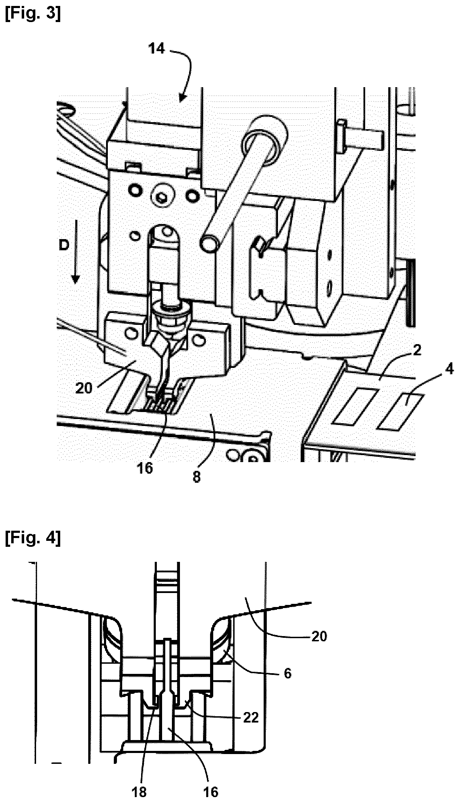

Les figures 3 et 4 présentent après la détection du composant 6 par la tête de lecture laser 10, la descente D de la tête de préhension 14. La forme de préhension s'ajuste progressivement autour du corps du composant 6, en le repositionnant si nécessaire, et les deux becs 22 des mors 20 viennent de chaque côté de la broche centrale 16.

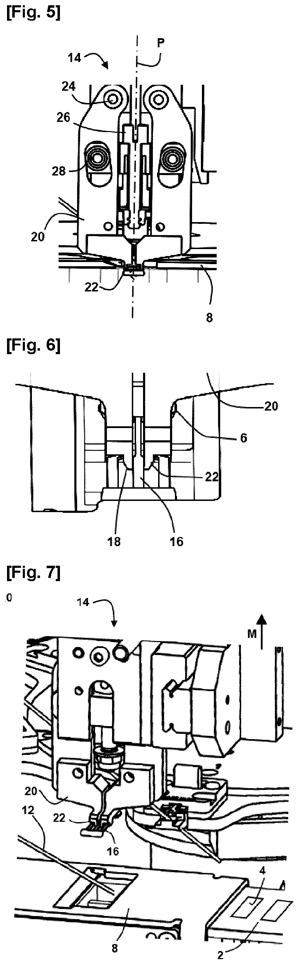

Les figures 5 et 6 présentent la rotation de la vis 26 entraînant la descente des roulements 28, qui resserrent de manière progressive les deux becs inférieurs 22 sur les côtés de la broche centrale 16.

Chaque bec inférieur 22 comporte un petit rebord inférieur 18 tourné vers le rebord de l'autre bec, formant un appui venant en dessous de la broche centrale 16 pour se prendre en dessous de cette broche afin de pouvoir la soulever sans risquer de la perdre.

La figure 7 présente la montée M de la tête de préhension 14, qui emporte avec elle le composant 6.

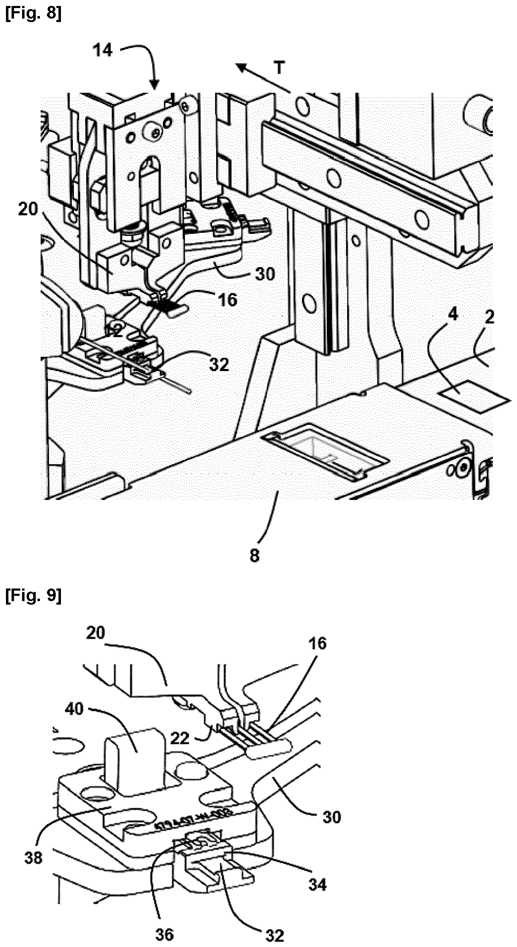

La figure 8 présente la translation horizontale T suivant l'axe X de la tête de préhension 14, qui vient aligner verticalement le composant 6 au-dessus d'un posage 32 fixé sur le contour d'un plateau 30 tournant suivant un axe central vertical, comprenant plusieurs posages répartis régulièrement sur son pourtour.

La figure 9 présente le posage 32 comprenant un plan horizontal se terminant vers le centre du plateau 30 par un plan vertical disposé tangentiellement, formant un rebord de mise en référence latérale 34 vers ce centre.

Le plateau 30 comporte radialement vers l'intérieur du posage 32 une plaque de guidage 38 fixée sur le dessus de ce plateau, guidant une fourchette 36 formant une lame coulissant radialement vers l'extérieur, qui est commandée par un doigt de commande 40 dépassant au-dessus de cette plaque de guidage. Le doigt de commande 40 peut être actionné par un moyen non représenté, comprenant par exemple un électroaimant ou un vérin.

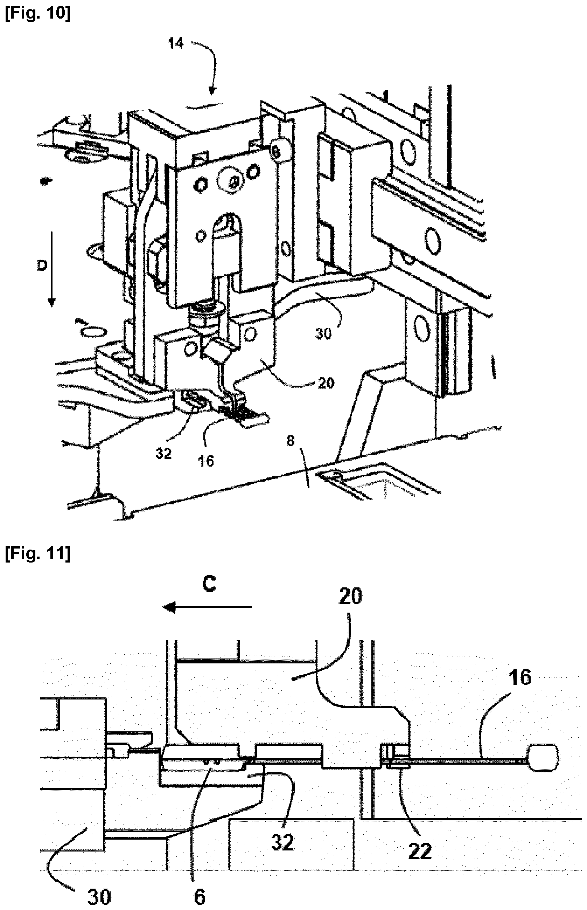

La figure 10 présente la descente D de la tête de préhension 14 qui dépose le corps du composant 6 sur le posage 32, en prévoyant suivant la direction radiale du plateau 30 un jeu entre ce corps et le rebord de référence latérale 34.

De cette manière le composant 6 descend sur une partie plate horizontale du posage 32 qui est libre, sans risquer de buter lors de cette descente sur le rebord de référence latérale 34 de ce posage qui pourrait appliquer sur le composant des contraintes mécaniques en le détériorant.

La figure 11 présente un petit mouvement horizontal C de la tête de préhension 14 radialement vers le centre du plateau 30, qui vient mettre en contact le côté du corps du composant 6 sur le rebord de référence latérale 34. De cette manière le composant 6 est indexé latéralement et en hauteur avec précision sur le plateau 30.

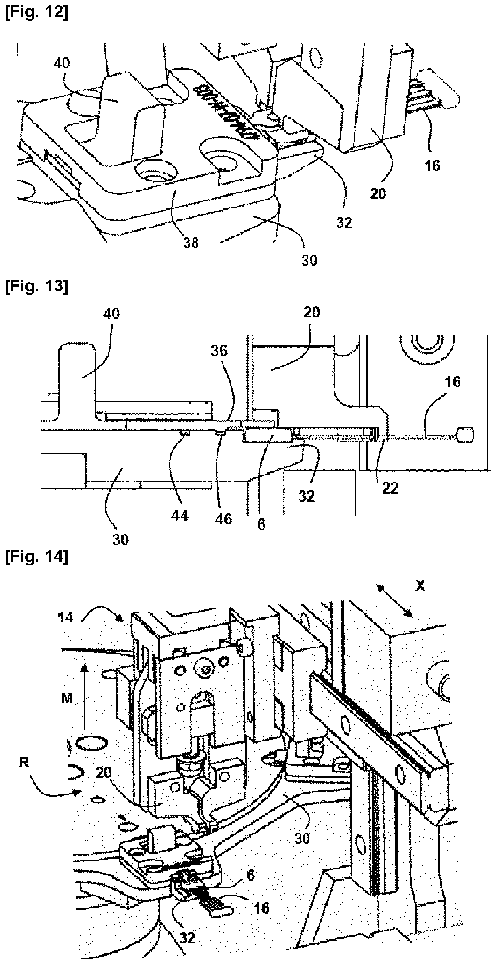

Les figures 12 et 13 présentent l'actionnement radialement vers l'extérieur du doigt de commande 40 faisant coulisser dans la même direction la fourchette 36 possédant un bossage sur sa face inférieure 46, qui dans ce mouvement va quitter un premier creux 44, puis passer un dos d'âne en décrivant un arc de cercle permettant à son extrémité de se soulever pour venir au-dessus du corps du composant 6.

En fin de course le bossage 46 descend dans un deuxième creux après le dos d'âne, ce qui plaque l'extrémité de la fourchette 36 sur le corps en le serrant avec une petite élasticité verticale pour maintenir dessus une légère pression, afin de le maintenir en position. Pendant ce mouvement la tête de préhension 14 peut rester en position afin d'éviter un mouvement du composant 6.

La fourchette 36 comporte un bossage inférieur 42 qui peut s'ajuster dans deux creux du plateau 30 formant des blocages de positions radiales, en quittant un creux arrière 44 maintenant cette fourchette en dehors du composant 6, pour s'engager dans un creux avant la maintenant sur ce composant.

La figure 14 présente enfin la montée M de la tête de préhension 14 qui libère entièrement le composant 6, cette tête effectuant ensuite une translation suivant l'axe horizontal X pour se repositionner au-dessus d'un nouveau composant 6 à prélever sur la bande 2.

Pendant ce temps le plateau 30 effectue une rotation R d'un pas pour présenter un nouveau posage vide 32 au poste d'arrivée, et faire avancer chaque composant 6 sur les postes d'opérations successifs réalisant la coupe et le cambrage des broches 16.

Le dernier poste atteint par le composant 6 avant le poste d'arrivée, est un poste de départ comprenant une autre tête de préhension qui va prendre le composant préparé pour le conditionner.

En particulier grâce à des commandes numériques des différents mouvements, le système mettant en œuvre le procédé de préhension selon l'invention permet facilement des positionnements ajustables en hauteur de la tête de préhension 14 en fonction de l'épaisseur des composants 6 arrivant, ce qui lui donne une grande flexibilité pour s'adapter à différents composants. On peut utiliser le procédé de préhension pour tous composants 6 en adaptant la forme de positionnement à la base de la tête de préhension 14 pour chaque composant différent.

## Revendications

1. Procédé de préhension de composants électroniques (6) disposant de broches de contact électrique (16), **caractérisé en ce qu'**il comporte successivement une étape de descente sensiblement verticale d'une tête de préhension (14) comprenant à sa base une forme de positionnement s'ajustant sur le corps du composant (6), et une pince à deux mors (20) équipée de deux becs inférieurs (22) venant de chaque côté d'une broche (16), une étape de fermeture des becs (22) sur cette broche (16), et enfin une étape de remontée et de déplacement de la tête de préhension (14), la dépose du composant (6) sur le posage (32) étant effectuée avec un jeu latéral par rapport à un rebord de ce posage formant une mise en référence (34).

2. Procédé de préhension selon la revendication 1, **caractérisé en ce qu'**il comporte une étape préliminaire de détection du composant (6) à son emplacement de préhension avec une tête de lecture laser (10).

3. Procédé de préhension selon la revendication 1 ou 2, **caractérisé en ce qu'**il comporte une étape finale de descente de la tête de préhension (14) et de dépose du composant (6) sur un posage horizontal (32).

4. Procédé de préhension selon l'une quelconque des revendication précédentes, **caractérisé en ce qu'**après la dépose du composant (6) sur le posage (32), il applique un mouvement latéral de ce composant (6) pour le mettre en contact avec le rebord de mise en référence (34).

5. Procédé de préhension selon la revendication 4, **caractérisé en ce qu'**après la mise en contact du composant (6) avec le rebord de mise en référence (34), il commande le coulissement horizontal d'une lame souple (36) liée au posage (32), venant en appui au-dessus du corps de ce composant (6).

6. Procédé de préhension selon l'une quelconque des revendications précédentes, **caractérisé en ce qu'**il réalise l'étape de fermeture des becs (22) sur la broche (16) avec un effort maitrisé au moyen d'une élasticité disposée entre un actionneur et les becs (22).

7. Procédé de préhension selon la revendication 6, **caractérisé en ce qu'**il commande un moteur pas à pas formant l'actionneur de fermeture des becs (22).

8. Système de préhension de composants (6), **caractérisé en ce qu'**il comporte une tête de préhension (14) se déplaçant en mettant en œuvre un procédé de préhension selon l'une quelconque des revendications précédentes, le système comportant un plateau tournant (30) comprenant des posages (32) répartis autour de ce plateau (30), recevant successivement les composants (6).

9. Système de préhension selon la revendication 8, **caractérisé en ce que** la tête de préhension (14) se déplace suivant un axe horizontal (X) et un axe vertical (Z).

10. Système de préhension selon l'une quelconque des revendications 8 ou 9, **caractérisé en ce que** la pince présentant un plan médian de symétrie (P), comporte une vis (26) disposée dans ce plan (P), entraînant un coulissement d'une barre transversale portant de chaque côté un doigt (28) engagé dans une lumière oblongue d'un des mors (20) pour faire pivoter ce mors.
